# EUROPEAN PATENT APPLICATION

(11) **EP 4 345 920 A1**
(43) Date of publication of application: **03.04.2024**
(21) Application number: 22926777.8
(22) Date of filing: 26.10.2022
(51) Int. Cl.: H01L 31/18, H01L 31/0216

(54) **PASSIVATED CONTACT BATTERY AND PREPARATION PROCESS THEREFOR**

(30) Priority: 16.02.2022 CN 202210141493
(71) Applicant: Tongwei Solar (Meishan) Co., Ltd., Meishan, Sichuan 620041 (CN)
(72) Inventor: CHEN, Hao, Meishan, Sichuan 620041 (CN); XU, Wenzhou, Meishan, Sichuan 620041 (CN); MENG, Xiajie, Meishan, Sichuan 620041 (CN); YAO, Qian, Meishan, Sichuan 620041 (CN); WANG, Xiupeng, Meishan, Sichuan 620041 (CN); XING, Guoqiang, Meishan, Sichuan 620041 (CN)
(74) Representative: Marks & Clerk LLP
(86) International application number: PCT/CN2022/127747
(87) International publication number: WO 2023/155473

(57) **Abstract**

A passivated contact battery and a preparation process therefor, which belongs to the field of solar cells. In the preparation process for the passivated contact battery, preparation of a back surface field passivation structure thereof comprises: growing a tunneling oxide layer on a back surface of a silicon wafer; growing an intrinsic silicon carbide layer on a surface of the tunneling oxide layer; growing a phosphorus-doped silicon carbide layer on a surface of the intrinsic silicon carbide layer; and performing annealing, so as to cause the silicon carbide and the phosphorus in the phosphorus-doped silicon carbide layer to form covalent bonds. The passivated contact battery can be obtained by means of the described preparation process, and same comprises a silicon wafer as well as a tunneling oxide layer, an intrinsic silicon carbide layer, and a phosphorus-doped silicon carbide layer which are sequentially stacked on a back surface of the silicon wafer. The present preparation process and the battery are able to effectively remedy the problem of serious film bursting of a back surface field passivation structure obtained by PECVD deposition; and silver paste corrosion resistance of the back surface can further be improved, thereby reducing a metal penetration phenomenon and reducing metal compounding.

## Description

### CROSS-REFERENCE TO RELATED APPLICATIONS

This application claims priority to Chinese Patent Application No. 202210141493.5, entitled "PASSIVATED CONTACT BATTERY AND PREPARATION PROCESS THEREFOR", filed on 16 February, 2022, the content of which is incorporated herein by reference in its entirety.

### TECHNICAL FIELD

The present disclosure relates to the field of solar cells, particularly relates to a passivated contact battery and a preparation process thereof.

### BACKGROUND

Compared with other conventional solar cells, passivated contact battery with doped oxide layers can significantly improve photoelectric conversion efficiency of solar cells, which has already occupied a certain market share at present and has very high industrialization value.

At present, the key part of the technology of the passivated contact battery with doped oxide layers lies in that firstly a tunneling oxide layer SiOₓ with a thickness of about 1.4 nm is grown on the backside of the battery, and then a phosphorus-doped n+-poly-Si (heavily doped polycrystalline silicon) film is deposited, which, after high-temperature annealing, can effectively reduce the backside recombination current density.

In the process of mass production of the passivated contact battery with doped oxide layers, the main technical routes are mainly the following two:

One is to deposit the tunneling oxide layer and the amorphous silicon film by low-pressure chemical vapor deposition (LPCVD), and then the film is doped by ion implantation or phosphorus diffusion to form the phosphorus-doped polycrystalline silicon; the other is based on the tubular PECVD (plasma enhanced chemical vapor deposition) deposition technology, which has a higher mass production advantage due to its less wraparound and being beneficial to control the appearance and yields.

However, on the one hand, there is a serious film explosion problem during the deposition of poly-Si by PECVD and the subsequent high-temperature annealing, resulting in a decrease in photoelectric conversion efficiency of the battery.

On the other hand, the heavily doped polycrystalline silicon on the backside has weak corrosion resistance to silver paste during screen printing, and is easily pierced by metal, thus metal recombination is increased, resulting in a decrease in photoelectric conversion efficiency.

### SUMMARY

A passivated contact battery and a preparation process thereof are provided in the present disclosure, which not only can significantly address the film explosion problem of the backside field passivated structure obtained by PECVD deposition, but also can improve the corrosion resistance of the backside to silver paste, thus the metal piercing phenomenon is reduced and the metal recombination is reduced.

Embodiments of the present disclosure is implemented as follows.

A preparation process of a passivated contact battery is provided in some embodiments of the present disclosure, and a preparation of a backside field passivated structure thereof may include:
growing a tunneling oxide layer on a backside of a silicon wafer;
growing an intrinsic silicon carbide layer on a surface of the tunneling oxide layer;
growing a phosphorus-doped silicon carbide layer on a surface of the intrinsic silicon carbide layer; and
performing annealing treatment to form a covalent bond between phosphorus and silicon carbide in the phosphorus-doped silicon carbide layer.

In the aforementioned technical solution, the intrinsic silicon carbide layer and the phosphorus-doped silicon carbide layer are successively grown on the surface of the tunneling oxide layer in the backside field structure, so as to replace the conventional polycrystalline silicon structures. In the PECVD deposition process, the film explosion problem can be significantly improved, which is beneficial to improve the passivation performance of the battery, and is beneficial to improve Voc (open-circuit voltage) and cell efficiency. Since SiCₓ has higher hardness compared to Poly-Si, the corrosion resistance of the backside to silver paste can be improved during sintering after screen printing. Therefore, the metal piercing phenomenon is reduced, and the metal recombination is reduced, which is also beneficial to improve Voc and cell efficiency.

Compared to Poly-Si, SiCₓ has more stable C-H bonds, resulting in a higher hydrogen content in SiCₓ and an increase in interfacial H content, which is beneficial to improve the passivation performance of the battery. The optical band gap of SiC is wider than that of polycrystalline silicon, which not only can reduce infrared parasitic absorption, be beneficial to improve current density, but also can effectively improve the cell efficiency and the bifaciality factor.

The intrinsic silicon carbide layer is spaced between the tunneling oxide layer and the phosphorus-doped silicon carbide layer as a buffer structure, which can further block phosphorus from passing through the tunneling oxide layer into the bulk silicon during the formation of the phosphorus-doped silicon carbide layer, thus effectively avoiding affecting the open-circuit voltage or the like of the battery.

In some optional embodiments, a thickness of the intrinsic silicon carbide layer can range from 5 nm to 80 nm;
optionally, the thickness of the intrinsic silicon carbide layer can range from 5 nm to 50 nm;
optionally, the thickness of the intrinsic silicon carbide layer can range from 20 nm to 30 nm.

In the aforementioned technical solutions, the intrinsic silicon carbide layer has a suitable thickness, which can play the roles of passivation and buffering well, and is beneficial to better achieve the improvement of Voc, Isc, and cell efficiency.

In some optional embodiments, a thickness of the phosphorus-doped silicon carbide layer can range from 20 nm to 200 nm;
optionally, the thickness of the phosphorus-doped silicon carbide layer can range from 100 nm to 150 nm.

In the aforementioned technical solution, the phosphorus-doped silicon carbide layer has a suitable thickness, which can play the roles of passivation and avoiding corrosion and piercing of paste, and is beneficial to better achieve the improvement of Voc, Isc, and cell efficiency.

In some optional embodiments, a total thickness of the intrinsic silicon carbide layer and the phosphorus-doped silicon carbide layer is less than or equal to 200 nm.

In the aforementioned technical solution, the total thickness of the intrinsic silicon carbide layer and the phosphorus-doped silicon carbide layer is controlled within a certain standard, which effectively improves Voc, Isc, and cell efficiency while balances the overall performance of the battery.

In some optional embodiments, in the step of growing the intrinsic silicon carbide layer, the intrinsic silicon carbide layer can be deposited by a plasma enhanced chemical vapor deposition method,

and/or in the step of growing the phosphorus-doped silicon carbide layer, the phosphorus-doped silicon carbide layer can be deposited by a plasma enhanced chemical vapor deposition method.

In the aforementioned technical solutions, the plasma enhanced chemical vapor deposition method is employed, which results in less wraparound and is beneficial to control the appearance and yields of the battery.

In some optional embodiments, in the step of growing the intrinsic silicon carbide layer, CH₄, SiH₄, and H₂ are introduced for reactive deposition. A volume ratio of CH₄ and SiH₄ is 1:(1 to 10).

In the aforementioned technical solution, the volume ratio of CH₄ and SiH₄ is suitable, which is beneficial for the intrinsic silicon carbide layer to play the roles of passivation and buffering well.

In some optional embodiments, in the step of growing the phosphorus-doped silicon carbide layer, CH₄, SiH₄, PH₃, and H₂ are introduced for reactive deposition. A volume ratio of CH₄ and SiH₄ is 1:(1 to 10).

In the aforementioned technical solution, the volume ratio of CH₄ and SiH₄ is suitable, which is beneficial for the phosphorus-doped silicon carbide layer to play the roles of passivation, reducing infrared absorption, and avoiding corrosion and piercing of the paste.

In some optional embodiments, in the step of performing annealing treatment, an annealing temperature can range from 600°C to 1000°C, and an annealing time can range from 10 min to 60 min;
optionally, the annealing temperature can range from 900°C to 940°C.

In the aforementioned technical solutions, the annealing treatment is performed under suitable annealing conditions, which ensures good crystallization and effective phosphorus doping of the backside field passivated structure, and is beneficial to better achieve the improvement of Voc, Isc, and cell efficiency.

In some optional embodiments, after the step of growing the phosphorus-doped silicon carbide layer and prior to the step of performing annealing treatment, the preparation process can further include: growing a SiOₓ mask layer on a surface of the phosphorus-doped silicon carbide layer.

In some optional embodiments, in the step of growing the SiOₓ mask layer on the surface of the phosphorus-doped silicon carbide layer, SiH₄ and N₂O can be introduced to deposit the SiOₓ mask layer by PECVD, and a thickness of the SiOₓ mask layer ranges from 10 nm to 50 nm.

In some optional embodiments, the annealing treatment can be performed using a tubular annealing furnace, and an annealing atmosphere is nitrogen (N₂) or oxygen (O₂).

In some optional embodiments, the preparation process can further include an RCA cleaning. Firstly, an oxide layer wraparound a front side during each step of the preparation of the backside field passivated structure and an oxide layer formed during annealing are removed by a chain hydrofluoric acid (HF), and then a front side silicon carbide wraparound layer is removed by transferring to an alkaline bath.

In some optional embodiments, the preparation process can further include depositing an aluminum oxide film and a silicon nitride film on a front side. The aluminum oxide (AlOₓ) film is deposited by a plasma enhanced atomic layer deposition or PECVD for passivation, and the silicon nitride (SiNₓ) film is deposited by PECVD for anti-reflection.

In some optional embodiments, the preparation process can further include depositing a backside silicon nitride film. A SiNₓ film is deposited by PECVD for hydrogen passivation of a backside film.

In some optional embodiments, in the step of growing the tunneling oxide layer, the tunneling oxide layer with a thickness of 0.5 nm to 2 nm can be formed by PEALD or PECVD.

In the aforementioned technical solutions, the SiOₓ mask layer is configured to protect the backside field passivated structure, which can effectively avoid the backside field passivated structure from being destroyed in the subsequent wraparound removing and cleaning processes.

A passivated contact battery is provided in other embodiments of the present disclosure, which can include: a silicon wafer, and a tunneling oxide layer, an intrinsic silicon carbide layer, and a phosphorus-doped silicon carbide layer that are successively stacked on a backside of the silicon wafer.

In the aforementioned technical solution, the passivated contact battery can be obtained by the preparation process according to some embodiments of the present disclosure.

### BRIEF DESCRIPTION OF THE DRAWINGS

To illustrate the technical solutions according to the embodiments of the present disclosure more clearly, the accompanying drawings for describing the embodiments are introduced briefly in the following. It should be noted that the accompanying drawings are only some embodiments of the present disclosure, thus shall not be seen as limiting the scope. Persons of ordinary skill in the art can derive other drawings from the accompanying drawings without creative efforts.

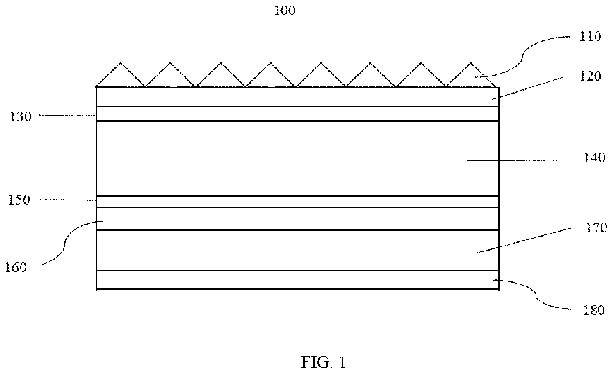

FIG. 1 is a schematic view of a passivated contact battery according to an embodiment of the present disclosure.

Reference numerals: 100, passivated contact battery; 110, front side anti-reflection layer; 120, front side passivation layer; 130, front side P-type doped layer; 140, silicon wafer; 150, tunneling oxide layer; 160, intrinsic silicon carbide layer; 170, phosphorus-doped silicon carbide layer; 180, backside passivation layer.

### DETAILED DESCRIPTION OF EMBODIMENTS

In order to make the purposes, technical solutions and advantages of the present disclosure clearer, the technical solutions in embodiments of the present disclosure will be clearly and completely described hereinafter. Embodiments with specific conditions not indicated are carried out under conventional conditions or conditions recommended by the manufacturer. The reagents or instruments used without indication of manufacturer are all conventional products that are commercially available.

It should be noted that the "and/or" in the present disclosure, such as "feature 1 and/or feature 2", refers to three cases of "feature 1" alone, "feature 2" alone, and "feature 1" and "feature 2".

In addition, In the description of this application, unless otherwise noted, the range "value a to value b" includes both ends of the value "a" and "b", and the "unit of measurement" in "value a to value b + unit of measurement" refers to the "unit of measurement" of both "value a" and "value b".

The preparation process of the passivated contact battery and the passivated contact battery according to embodiments of the present disclosure are described specifically hereinafter.

The inventor has discovered that in present, in the production of conventional polycrystalline silicon form of passivated contact battery with doped oxide layers, during the deposition of poly-Si by PECVD and subsequent high-temperature annealing, hydrogen in poly-Si is released, and leads to destruction of poly-Si film layer, resulting in film explosion phenomenon. Film explosion of poly-Si seriously affects the passivation performance of the battery, and leads to a decrease in photoelectric conversion efficiency of the battery. In addition, the heavily doped polycrystalline silicon has weak corrosion resistance to silver paste during screen printing, and is easily pierced by metal, thus metal recombination is increased, resulting in a decrease in photoelectric conversion efficiency.

Further researches show that compared to poly-Si deposited by PECVD, H in SiCₓ is difficult to escape. In the PECVD deposition process, the film explosion problem can be effectively mitigated. Furthermore, since SiCₓ has higher hardness compared to poly-Si, the corrosion resistance of the backside to silver paste can be improved during sintering in the annealing treatment, thus the metal piercing phenomenon and the metal recombination are reduced.

Based on the aforementioned researches, a preparation process of a passivated contact battery is provided in some embodiments of the present disclosure, and a preparation of a backside field passivated structure thereof may include:
a tunneling oxide layer is grown on a backside of a silicon wafer;
an intrinsic silicon carbide layer is grown on a surface of the tunneling oxide layer;
a phosphorus-doped silicon carbide layer is grown on a surface of the intrinsic silicon carbide layer; and
an annealing treatment is performed to form a covalent bond between phosphorus and silicon carbide in the phosphorus-doped silicon carbide layer.

In the preparation process of the passivated contact battery according to the present disclosure, the intrinsic silicon carbide layer and the phosphorus-doped silicon carbide layer are successively grown on the surface of the tunneling oxide layer in the backside field structure, so as to replace the conventional polycrystalline silicon structures. The preparation process of the passivated contact battery according to the present disclosure has at least the following effects.
1. Compared to poly-Si deposited by PECVD, H in SiCₓ is difficult to escape. In the PECVD deposition process, in the PECVD deposition process, the film explosion problem can be significantly improved, which not only is beneficial to improve the passivation performance of the battery, but also is beneficial to improve Voc and cell efficiency.
2. Since SiCₓ has higher hardness compared to poly-Si, the corrosion resistance of the backside to silver paste can be improved during sintering in the annealing treatment, thus the metal piercing phenomenon the metal recombination are reduced, which is also beneficial to improve Voc and cell efficiency.
3. Compared to poly-Si, SiCₓ has more stable C-H bonds, resulting in a higher hydrogen content in SiCₓ and an increase in interfacial H content, which is beneficial to improve the passivation performance of the battery.
4. The optical band gap of SiC is wider than that of polycrystalline silicon, which not only can reduce infrared parasitic absorption, be beneficial to improve current density, but also can effectively improve the cell efficiency and the bifaciality factor.

In addition, in the preparation process of the passivated contact battery according to the present disclosure, the inventor has discovered that when poly-Si is replaced by SiCₓ, and meanwhile the intrinsic silicon carbide layer is spaced between the tunneling oxide layer and the phosphorus-doped silicon carbide layer, the intrinsic silicon carbide layer serves as a buffer structure, which can further block phosphorus from passing through the tunneling oxide layer into the bulk silicon during the formation of the phosphorus-doped silicon carbide layer, thus effectively avoiding affecting the open-circuit voltage or the like of the battery.

It should be noted that the above mainly shows the preparation process of the backside field passivated structure. In the preparation process of the passivated contact battery, other steps such as texturing, p-n junction formation, wraparound removing, mask formation, electrode manufacturing, and the like may also be performed as required or in a conventional manner.

In some exemplary embodiments, the preparation process of the passivated contact battery can include:
Texturing. Exemplarily, an N-type silicon wafer is prepared, texturing is performed using 1% alkaline solution, and the wafer is cleaned using hydrogen peroxide and alkali.

Boron diffusion. Exemplarily, the wafer enters a boron diffusion furnace, and a p-n junction is formed by diffusion at 900 to 1050°C using BCl₃.

Alkaline polishing. Exemplarily, a backside boron diffused and wraparound BSG (borosilicate glass) is removed by a chain HF machine, and the wafer is then transferred by manipulator to a trough type alkaline polishing machine to remove backside and edge p-n junctions.

A tunneling oxide layer is grown on a backside of the silicon wafer.

An intrinsic silicon carbide layer is grown on a surface of the tunneling oxide layer.

A phosphorus-doped silicon carbide layer is grown on a surface of the intrinsic silicon carbide layer.

Annealing treatment. Exemplarily, a tubular annealing furnace is used, and an annealing atmosphere is nitrogen (N₂) or oxygen (O₂).

RCA cleaning. Exemplarily, firstly an oxide layer wraparound a front side during each step of the preparation of the backside field passivated structure and an oxide layer formed during annealing are removed by chain hydrofluoric acid (HF), and then a front side silicon carbide wraparound layer is removed by transferring to an alkaline bath.

An aluminum oxide film and a silicon nitride film are deposited on a front side. Exemplarily, the aluminum oxide (AlOₓ) film is deposited by PEALD (plasma enhanced atomic layer deposition) or PECVD for passivation, and the silicon nitride (SiNₓ) film is deposited by PECVD for anti-reflection.

A backside silicon nitride film is deposited. Exemplarily, the SiNₓ film is deposited by PECVD for hydrogen passivation of a backside film.

An electrode is manufactured. Exemplarily, front side and backside pastes are screen printed.

Electricity is injected, efficiency is test, and sorted.

Regarding each step of the preparation of the backside field passivated structure, some exemplary embodiments are illustrated below.

Regarding the step that the tunneling oxide layer is grown:
As an example, the tunneling oxide layer with a thickness of 0.5 nm to 2 nm is formed by PEALD or PECVD.

Regarding the step that the intrinsic silicon carbide layer is grown:

As an example, the intrinsic silicon carbide layer is deposited by PECVD. The plasma enhanced chemical vapor deposition method is employed, which results in less wraparound and is beneficial to control the appearance and yields of the battery.

As an example, in the step of growing the intrinsic silicon carbide layer, CH₄, SiH₄, and H₂ are introduced for reactive deposition. A volume ratio of CH₄ and SiH₄ is 1:(1 to 10), which, for example, can be but not limited to, any one of or range value between any two of 1:1, 1:2, 1:3, 1:4, 1:5, 1:6, 1:7, 1:8, 1:9, and 1:10. In this design, the volume ratio of CH₄ and SiH₄ is suitable, which is beneficial for the intrinsic silicon carbide layer to play the roles of passivation and buffering well.

As an example, a thickness of the intrinsic silicon carbide layer ranges from 5 nm to 80 nm. Optionally, the thickness of the intrinsic silicon carbide layer ranges from 5 nm to 50 nm. Optionally, the thickness of the intrinsic silicon carbide layer ranges from 20 nm to 30 nm.

The thickness of the intrinsic silicon carbide layer is, for example, but not limited to, any one of or range value between any two of 5 nm, 10 nm, 20 nm, 25 nm, 30 nm, 40 nm, 50 nm, and 80 nm. Since the thickness of the intrinsic silicon carbide layer is suitable, it can play the roles of passivation, reducing infrared absorption, and buffering well, and is beneficial to better achieve the improvement of Voc, Isc, and cell efficiency.

Regarding the step that the phosphorus-doped silicon carbide layer is grown:
As an example, the phosphorus-doped silicon carbide layer is deposited by PECVD. The plasma enhanced chemical vapor deposition method is employed, which results in less wraparound and is beneficial to control the appearance and yields of the battery.

As an example, in the step of growing the phosphorus-doped silicon carbide layer, CH₄, SiH₄, PH₃, and H₂ are introduced for reactive deposition. A volume ratio of CH₄ and SiH₄ is 1:(1 to 10), which, for example, can be but not limited to, any one of or range value between any two of 1:1, 1:2, 1:3, 1:4, 1:5, 1:6, 1:7, 1:8, 1:9, and 1: 10. In this design, the volume ratio of CH₄ and SiH₄ is suitable, which is beneficial for the phosphorus-doped silicon carbide layer to play the roles of passivation and avoiding corrosion and piercing of paste.

As an example, a thickness of the phosphorus-doped silicon carbide layer ranges from 20 nm to 200 nm. Optionally, the thickness of the phosphorus-doped silicon carbide layer ranges from 100 nm to 150 nm.

The thickness of the phosphorus-doped silicon carbide layer is, for example, but not limited to, any one of or range value between any two of 20 nm, 50 nm, 80 nm, 100 nm, 120 nm, 150 nm, and 200 nm. Since the thickness of the phosphorus-doped silicon carbide layer is suitable, it can play the roles of passivation and avoiding corrosion and piercing of paste, and is beneficial to better achieve the improvement of Voc, Isc, and cell efficiency.

Further optionally, a total thickness of the intrinsic silicon carbide layer and the phosphorus-doped silicon carbide layer is less than or equal to a sum of the respective thicknesses less than or equal to. The total thickness of the intrinsic silicon carbide layer and the phosphorus-doped silicon carbide layer is controlled within a certain standard, which effectively improves Voc and cell efficiency while balances the overall performance of the battery.

In some optional embodiments, after the step of growing the phosphorus-doped silicon carbide layer and prior to the step of annealing treatment, the preparation process further includes: a SiOₓ mask layer is grown on a surface of the phosphorus-doped silicon carbide layer.

As an example, SiH₄ and N₂O are introduced to deposit the SiOₓ mask layer by PECVD. A thickness of the SiOₓ mask layer ranges from 10 nm to 50 nm, which, for example, can be but not limited to 10 nm, 20 nm, 30 nm, 40 nm, or 50 nm.

In the aforementioned embodiment, the SiOₓ mask layer serves to protect the backside field passivated structure, which can effectively avoid the backside field passivated structure from being destroyed in the subsequent wraparound removing and cleaning processes.

Regarding each aforementioned step, in some exemplary embodiments, when films of the tunneling oxide layer, the intrinsic silicon carbide layer, the phosphorus-doped silicon carbide layer, and the SiOₓ mask layer are all deposited using PECVD equipment, the plurality of film layers can be deposited in the same tube at one time without breaking the vacuum. Of course, it should be noted that in the present disclosure, there is no limitation to the formation manner of each film layer, which can be, for example, but not limited to, plasma enhanced physical vapor deposition (PVD), chemical vapor deposition (CVD), metal organic chemical vapor deposition (MOCVD), and the like.

Regarding the step of annealing treatment, an annealing temperature ranges from 600°C to 1000°C. Optionally, the annealing temperature ranges from 900 to 9400, which, for example, can be but not limited to, any one of or range value between any two of 600°C, 700°C, 800°C, 900°C, 910°C, 920°C, 930°C, 940°C, 950°C, and 1000°C.

An annealing time ranges from 10 min to 60 min. The annealing time is, for example, but not limited to, any one of or range value between any two of 10 min, 20 min, 30 min, 40 min, 50 min, and 60 min.

In the aforementioned embodiments, the annealing treatment is performed under suitable annealing conditions, which ensures good crystallization and effective phosphorus doping of the backside field passivated structure, such that phosphorus in the phosphorus-doped silicon carbide layer forms covalent bond with silicon carbide well, and can provide electrons to form passivation structure, thereby being beneficial to better achieve the improvement of Voc and cell efficiency.

Referring to FIG. 1, a passivated contact battery 100 is provided in other embodiments of the present disclosure, which can be obtained by the preparation process according to some embodiments of the present disclosure.

The passivated contact battery 100 can include a silicon wafer 140, and a tunneling oxide layer 150, an intrinsic silicon carbide layer 160, and a phosphorus-doped silicon carbide layer 170 that are successively stacked on a backside of the silicon wafer 140.

It should be noted that, the above mainly shows the structure corresponding to the backside field passivated structure. In the passivated contact battery, other anti-reflection layers, passivation layers, electrodes, and the like may also be configured according to functional needs and battery design.

Continuing with reference to FIG. 1, in some exemplary embodiments, the passivated contact battery 100 can include a front side anti-reflection layer 110, a front side passivation layer 120, a front side P-type doped layer 130, an N-type silicon wafer 140, the tunneling oxide layer 150, the intrinsic silicon carbide layer 160, the phosphorus-doped silicon carbide layer 170, and a backside passivation layer 180 that are provided successively.

Optionally, the front side anti-reflection layer 110 can be a SiNₓ anti-reflection layer, the front side passivation layer 120 can be a AlOₓ passivation layer, and the backside passivation layer 180 can be a SiNₓ passivation layer.

Features and performances of the present disclosure are further described in detail hereinafter in combination with the embodiments.

### Example 1

A preparation process of a passivated contact battery included:
S1, texturing: an N-type silicon wafer was prepared, texturing was performed using 1% alkaline solution, and the wafer was cleaned using hydrogen peroxide and alkali.
S2, boron diffusion: the wafer entered a boron diffusion furnace, and the p-n junction was formed by diffusion at 1000°C using BCl₃.
S3, alkaline polishing: a backside boron diffused and wraparound BSG was removed by a chain HF machine, and the wafer was then transferred by manipulator to a trough type alkaline polishing machine to remove backside and edge p-n junctions.
S4, growing a tunneling oxide layer on a backside of the silicon wafer: O₂ was introduced, and a tunneling oxide layer SiOₓ with a thickness of 1 nm was grown by PECVD.
S5, growing an intrinsic silicon carbide layer on a surface of the tunneling oxide layer: CH₄, SiH₄, and H₂ were introduced for reactive deposition by PECVD. A volume ratio of CH₄ and SiH₄ was 1: 10 and a thickness of the intrinsic silicon carbide layer was 30 nm.
S6, growing a phosphorus-doped silicon carbide layer on a surface of the intrinsic silicon carbide layer: CH₄, SiH₄, PH₃, and H₂ were introduced for reactive deposition by PECVD. A volume ratio of CH₄ and SiH₄ was 1: 10 and a thickness of the phosphorus-doped silicon carbide layer was 100 nm.
S7, growing a SiOₓ mask layer on a surface of the phosphorus-doped silicon carbide layer: SiH₄ and N₂O were introduced, and the SiOₓ mask layer with a thickness of 20 nm was deposited by PECVD.
S8, annealing treatment: a tubular annealing furnace was used, an annealing atmosphere was nitrogen (N₂), an annealing temperature was 900°C, and an annealing time was 20 min.
S9, RCA cleaning: firstly an oxide layer wraparound a front side during steps S4 to S7 and an oxide layer formed during annealing in step S8 were removed by chain hydrofluoric acid (HF), and then a front side silicon carbide wraparound layer was removed by transferring to an alkaline bath.
S10, depositing an aluminum oxide film and a silicon nitride film on the front side: the aluminum oxide film was deposited by PEALD for passivation, and the silicon nitride film was deposited by PECVD for anti-reflection.
S11, depositing a backside silicon nitride film: the SiNₓ film was deposited by PECVD for hydrogen passivation of a backside film.
S12, an electrode was manufactured. Exemplarily, front side and backside pastes were screen printed.
S13, electricity was injected, efficiency was test, and sorted.

### Example 2

A preparation process of a passivated contact battery was provided, the difference between which and Example 1 only lies in:
In step S5, the volume ratio of CH₄ and SiH₄ was 1:5.

### Example 3

A preparation process of a passivated contact battery was provided, the difference between which and Example 1 only lies in:

In step S5, the thickness of the intrinsic silicon carbide layer was 5 nm.

### Example 4

A preparation process of a passivated contact battery was provided, the difference between which and Example 1 only lies in:
In step S5, the thickness of the intrinsic silicon carbide layer was 80 nm.

### Example 5

A preparation process of a passivated contact battery was provided, the difference between which and Example 1 lies in:
In step S6, the thickness of the phosphorus-doped silicon carbide layer was 20 nm.

### Example 6

A preparation process of a passivated contact battery was provided, the difference between which and Example 1 only lies in:
In step S6, the thickness of the phosphorus-doped silicon carbide layer was 200 nm.

### Example 7

A preparation process of a passivated contact battery was provided, the difference between which and Example 1 only lies in:
In step S8, the annealing temperature was 940°C.

Some experimental conditions in each embodiment are summarized in Table 1.

**Table 1 Summary of experimental conditions in embodiments**

| Step | Growing the intrinsic silicon carbide layer | | Growing the phosphorus-doped silicon carbide layer | Annealing treatment |
|---|---|---|---|---|
| Item | Volume ratio of CH₄ and SiH₄ | Thickness (nm) | Thickness (nm) | Annealing temperature (°C) |
| Example 1 | 1:10 | 30 | 100 | 900 |
| Example 2 | 1:5 | 30 | 100 | 900 |
| Example 3 | 1:10 | 5 | 100 | 900 |
| Example 4 | 1:10 | 80 | 100 | 900 |
| Example 5 | 1:10 | 30 | 20 | 900 |
| Example 6 | 1:10 | 30 | 80 | 900 |
| Example 7 | 1:10 | 30 | 100 | 940 |

### Comparative Example 1

A preparation process of a passivated contact battery was provided, which was a conventional polycrystalline silicon process, the difference between which and Example 1 lies in: instead of depositing the intrinsic silicon carbide layer and the phosphorus-doped silicon carbide layer, an n+-poly-Si film was deposited. Specifically:

Steps S4 to S7 were replaced by: a tunneling oxide layer and an intrinsic polycrystalline silicon were grown using a LPCVD equipment, oxygen was introduced, the tunneling oxide layer was grown, and a film thickness was 1 nm; oxygen was turned off, silane was introduced, and the intrinsic polycrystalline silicon of 130 nm was grown.

Step S8 was replaced by: a tubular diffusion furnace was used instead, phosphine was introduced and phosphorus doping was performed.

### Experimental Example

The electrical performances of the passivated contact batteries prepared from each Example and Comparative Example were tested, and the test results are shown in Table 2.

**Table 2 The electrical performances of the passivated contact batteries**

| Item | Eta (%) | Voc (mV) | Isc (A) | FF (%) |
|---|---|---|---|---|
| Example 1 | 24.31 | 712.5 | 18.08 | 83.23 |
| Example 2 | 24.27 | 713.1 | 18.07 | 83.07 |
| Example 3 | 24.18 | 709.8 | 18.08 | 83.08 |
| Example 4 | 24.15 | 711.1 | 18.07 | 82.87 |
| Example 5 | 24.15 | 709.5 | 18.14 | 82.75 |
| Example 6 | 24.17 | 714.1 | 17.89 | 83.43 |
| Example 7 | 24.33 | 711.7 | 18.08 | 83.37 |
| Comparative Example 1 | 24.16 | 710.2 | 18.02 | 83.26 |

According to Table 1, the passivated contact batteries provided in Examples 1 to 7 have good overall electrical performance. In which:
Compared to the conventional polycrystalline silicon process, in the passivated contact battery provided in Example 1, Voc increases by 2.3 mV, Isc increases by 60 mA, the photoelectric conversion efficiency of the battery increases by 0.15%, and overall electrical performance of the battery is relatively highly improved.

Compared to the conventional polycrystalline silicon process, in the passivated contact battery provided in Example 2, Voc increases by 2.9 mV, Isc increases by 50 mA, the photoelectric conversion efficiency of the battery increases by 0.11%, and overall electrical performance of the battery is relatively highly improved.

In the passivated contact battery provided in Example 3, the thickness of the intrinsic silicon carbide layer is relatively small. Compared to the conventional polycrystalline silicon process, Isc increases by 60 mA, and the photoelectric conversion efficiency of the battery is comparable.

In the passivated contact battery provided in Example 4, the thickness of the intrinsic silicon carbide layer is relatively large. Compared to the conventional polycrystalline silicon process, Isc increases by 50 mA, Voc increases by 0.9 mV, and the photoelectric conversion efficiency of the battery is comparable.

In the passivated contact battery provided in Example 5, the thickness of the phosphorus-doped silicon carbide layer is relatively small. Compared to the conventional polycrystalline silicon process, Isc increases by 120 mA, and the photoelectric conversion efficiency of the battery is comparable.

In the passivated contact battery provided in Example 6, the thickness of the phosphorus-doped silicon carbide layer is relatively large. Compared to the conventional polycrystalline silicon process, Voc increases by 3.9 mA, FF increases by 0.17%, and the photoelectric conversion efficiency of the battery is comparable.

Compared to the conventional polycrystalline silicon process, in the passivated contact battery provided in Example 7, Voc increases by 1.5 mV, Isc increases by 60 mA, FF increases by 0.11%, the photoelectric conversion efficiency of the battery increases by 0.16%, and overall electrical performance of the battery is relatively highly improved.

The embodiments described above are only a part rather than all of the embodiments of the present disclosure. The detailed description of the embodiments of the present disclosure is not intended to limit the protection scope of the present disclosure claimed, but merely to illustrate selected embodiments of the present disclosure. All other embodiments obtained by persons skilled in the art based on the embodiments of the present disclosure without creative efforts shall fall within the protection scope of the present application.

### Industrial utility

A passivated contact battery and a preparation process thereof are provided in the present disclosure, which belongs to the field of solar cells. In the preparation process of the passivated contact battery, a preparation of a backside field passivated structure thereof may include: a tunneling oxide layer is grown on a backside of a silicon wafer; an intrinsic silicon carbide layer is grown on a surface of the tunneling oxide layer; a phosphorus-doped silicon carbide layer is grown on a surface of the intrinsic silicon carbide layer; and an annealing treatment is performed to form a covalent bond between phosphorus and silicon carbide in the phosphorus-doped silicon carbide layer. The passivated contact battery can be obtained by the aforementioned preparation process, which includes a silicon wafer, and a tunneling oxide layer, an intrinsic silicon carbide layer, and a phosphorus-doped silicon carbide layer that are successively stacked on a backside of the silicon wafer. The preparation process and the battery not only can effectively mitigate the film explosion problem of the backside field passivated structure obtained by PECVD deposition, but also can improve the corrosion resistance of the backside to silver paste, thus reducing metal piercing phenomenon and metal recombination.

In addition, it can be understood that the passivated contact battery and the preparation process thereof are reproducible and can be used in various industrial applications. For example, the passivated contact battery and the preparation process thereof according to the present disclosure can be used in the field of solar cells.

## Claims

1. A preparation process of a passivated contact battery, a preparation of a backside field passivated structure thereof comprising:
growing a tunneling oxide layer on a backside of a silicon wafer;
growing an intrinsic silicon carbide layer on a surface of the tunneling oxide layer;
growing a phosphorus-doped silicon carbide layer on a surface of the intrinsic silicon carbide layer; and
performing annealing treatment to form a covalent bond between phosphorus and silicon carbide in the phosphorus-doped silicon carbide layer.

2. The preparation process according to claim 1, wherein a thickness of the intrinsic silicon carbide layer ranges from 5 nm to 80 nm;
optionally, the thickness of the intrinsic silicon carbide layer ranges from 5 nm to 50 nm;
optionally, the thickness of the intrinsic silicon carbide layer ranges from 20 nm to 30 nm.

3. The preparation process according to claim 1 or 2, wherein a thickness of the phosphorus-doped silicon carbide layer ranges from 20 nm to 200 nm;
optionally, the thickness of the phosphorus-doped silicon carbide layer ranges from 100 nm to 150 nm.

4. The preparation process according to any one of claims 1 to 3, wherein a total thickness of the intrinsic silicon carbide layer and the phosphorus-doped silicon carbide layer is less than or equal to 200 nm.

5. The preparation process according to any one of claims 1 to 4, wherein in the step of growing the intrinsic silicon carbide layer, the intrinsic silicon carbide layer is deposited by a plasma enhanced chemical vapor deposition method;
and/or, in the step of growing the phosphorus-doped silicon carbide layer, the phosphorus-doped silicon carbide layer is deposited by a plasma enhanced chemical vapor deposition method.

6. The preparation process according to claim 1, 2 or 5, wherein in the step of growing the intrinsic silicon carbide layer, CH₄, SiH₄, and H₂ are introduced for reactive deposition, wherein a volume ratio of CH₄ and SiH₄ is 1:(1 to 10).

7. The preparation process according to claim 1, 3 or 5, wherein in the step of growing the phosphorus-doped silicon carbide layer, CH₄, SiH₄, PH₃, and H₂ are introduced for reactive deposition, wherein a volume ratio of CH₄ and SiH₄ is 1:(1 to 10).

8. The preparation process according to any one of claims 1 to 7, wherein in the step of performing annealing treatment, an annealing temperature ranges from 600°C to 1000°C, and an annealing time ranges from 10 min to 60 min;
optionally, the annealing temperature ranges from 900°C to 940°C.

9. The preparation process according to any one of claims 1 to 8, wherein after the step of growing the phosphorus-doped silicon carbide layer and prior to the step of performing annealing treatment, the preparation process further comprises: growing a SiOₓ mask layer on a surface of the phosphorus-doped silicon carbide layer.

10. The preparation process according to claim 9, wherein in the step of growing the SiOₓ mask layer on the surface of the phosphorus-doped silicon carbide layer, SiH₄ and N₂O are introduced to deposit the SiOₓ mask layer by PECVD, and a thickness of the SiOₓ mask layer ranges from 10 nm to 50 nm.

11. The preparation process according to any one of claims 1 to 10, wherein the annealing treatment is performed using a tubular annealing furnace, and an annealing atmosphere is nitrogen (N₂) or oxygen (O₂).

12. The preparation process according to any one of claims 1 to 11, further comprising RCA cleaning, wherein firstly an oxide layer wraparound a front side during each step of the preparation of the backside field passivated structure and an oxide layer formed during annealing are removed by a chain hydrofluoric acid (HF), and then a front side silicon carbide wraparound layer is removed by transferring to an alkaline bath.

13. The preparation process according to any one of claims 1 to 12, further comprising depositing an aluminum oxide film and a silicon nitride film on a front side, wherein the aluminum oxide (AlOₓ) film is deposited by a plasma enhanced atomic layer deposition or PECVD for passivation, and the silicon nitride (SiNₓ) film is deposited by PECVD for anti-reflection.

14. The preparation process according to any one of claims 1 to 13, further comprising depositing a backside silicon nitride film, wherein a SiNₓ film is deposited by PECVD for hydrogen passivation of a backside film.

15. The preparation process according to any one of claims 1 to 14, wherein in the step of growing the tunneling oxide layer, the tunneling oxide layer with a thickness of 0.5 nm to 2 nm is formed by PEALD or PECVD.

16. A passivated contact battery, comprising: a silicon wafer, and a tunneling oxide layer, an intrinsic silicon carbide layer, and a phosphorus-doped silicon carbide layer that are successively stacked on a backside of the silicon wafer.
